# EUROPÄISCHE PATENTANMELDUNG

(11) **EP 3 611 761 A1**
(43) Veröffentlichungstag der Anmeldung: **19.02.2020**
(21) Anmeldenummer: 18188744.9
(22) Anmeldetag: 13.08.2018
(51) Int. Cl.: H01L 23/488, H01L 21/60

(54) **VERFAHREN UND METALLSUBSTRAT ZUM KONTAKTIEREN EINES LEISTUNGSHALBLEITERS DURCH EIN KONTAKTIERUNGSMITTEL MIT ZUMINDEST EINEM KONTAKTIERUNGSFREIEN BEREICH ALS BELASTUNGSREDUZIERENDE STRUKTUR**

(71) Anmelder: Heraeus Deutschland GmbH & Co KG, 63450 Hanau (DE)
(72) Erfinder: DIETRICH, Peter, 63322 Roedermark (DE); HINRICH, Andreas, 63579 Freigericht (DE)
(74) Vertreter: Heraeus IP

(57) **Zusammenfassung**

Ein Verfahren zum Kontaktieren eines Leistungshalbleiters weist die Schritte auf:
Bereitstellen eines Leistungshalbleiters mit zumindest einer Kontaktfläche (5a, 5b);
Aufbringen zumindest teilweise auf die Kontaktfläche (5a, 5b) zumindest eines Kontaktierungsmittels (3a, 3b) als belastungsreduzierende Struktur und Anordnen zumindest einer Oberfläche eines Metallsubstrats (1) zumindest bereichsweise auf der Kontaktfläche (5a, 5b), oder Aufbringen zumindest teilweise auf die Oberfläche des Metallsubstrats (1) des Kontaktierungsmittels (3a, 3b) als belastungsreduzierende Struktur und Anordnen zumindest bereichsweise der Kontaktfläche (5a, 5b) auf der Oberfläche des Metallsubstrats (1); und
Verbinden der Kontaktfläche (5a, 5b) mit der Oberfläche des Metallsubstrats (1).

Das Aufbringen des Kontaktierungsmittels (3a, 3b) als belastungsreduzierende Struktur umfasst ein Aufbringen des Kontaktierungsmittels (3a. 3b) auf zumindest einen ersten Bereich (9), bevorzugt auf erste Bereiche (9), der Kontaktfläche (5a, 5b) des Leistungshalbleiters oder der Oberfläche des Metallsubstrats (1), wobei zumindest ein kontaktierungsmittelfreier zweiter Bereich (7a-7n), bevorzugt zweite Bereiche (7a-7n), zwischen den mit Kontaktierungsmittel (3a, 3b) bedeckten ersten Bereichen (9) angeordnet ist.

Durch das Kontaktierungsmittel als belastungsreduzierende Struktur werden mechanische Spannungen im Kontaktierungsbereich abgebaut und die Wahrscheinlichkeit einer Ablösung der Kontaktierung reduziert.

## Beschreibung

Die vorliegende Erfindung betrifft ein Verfahren zum Kontaktieren eines Leistungshalbleiters. Weiterhin betrifft die vorliegende Erfindung ein Metallsubstrat zum Kontaktieren eines Leistungshalbleiters.

Im Stand der Technik werden Bonddrähte, bzw. Bondverbindungen häufig bei Leistungshalbleitern verwendet, um die Leistungshalbleiter elektrisch zu kontaktieren. Typischerweise weist der Leistungshalbleiter in dem zu kontaktierenden Bereich eine Kontaktfläche, beispielweise einen Last- oder Steueranschluss, meist aus Aluminium oder einer Aluminiumlegierung auf. Die Kontaktierung des Leistungshalbleiters erfolgt dabei mittels einer zwischen der Kontaktfläche und dem Bonddraht ausgebildeten Bondverbindung. Abhängig von dem zu führenden Strom steigt auch der Durchmesser der Bonddrähte, wobei die Lebensdauer der Bondverbindung mit steigendem Durchmesser abnimmt. Zur Erhöhung der Lebensdauer von Leistungshalbleiterschaltungen wird deshalb in der DE 10 2014 008 587 A1 eine Kontaktierung einer Kontaktfläche von einem Leistungshalbleiters mit einem Bonding-Leiterband beschrieben. Eine derartige Kontaktierung ermöglicht eine elektrische Anbindung größere Bereiche der Kontaktfläche und somit einen hohen Kontaktleitwert.

Allerdings kann die Verbindung zwischen Kontaktfläche und Bonding-Leiterband durch zyklische Temperaturbelastungen wechselnden mechanischen Spannungen ausgesetzt sein. Diese mechanischen Spannungen können gerade bei großflächigen Kontaktierungen zu einer Ablösung der Kontaktierung führen. Deshalb schlägt die DE 10 2014 008 587 A1 ein Einbringen von Ausnehmungen als belastungsreduzierende Strukturen in den Abschnitt des Bonding-Leiterbands vor, der die Kontaktfläche des Leistungshalbleiters kontaktiert.

Durch das Einbringen von Ausnehmungen in das Material des Bonding-Leiterbands können mechanische Spannungen abgebaut werden und die Wahrscheinlichkeit einer Ablösung der Kontaktierung reduziert werden.

Allerdings hat die aus dem Stand der Technik bekannt Lösung den Nachteil, dass das Bearbeiten des Bonding-Leiterbands sehr ressourcenintensiv ist. Die Aussparungen müssen in einem zusätzlichen Arbeitsschritt mechanisch in das Material des Bonding-Leiterbands eingebracht werden. Beispielsweise werden die Aussparungen in das Bonding-Leiterband mit einem entsprechenden Stanzwerkzeug eingebracht. Auch kann das mechanische Einbringen die Widerstandsfähigkeit des Bonding-Leiterbands gegen von außen einwirkenden mechanischen Belastungen herabsetzen. Außerdem ist die Auswahl der zur Verfügung stehenden Geometrien für die Aussparungen begrenzt.

Aufgabe der vorliegenden Erfindung ist es daher, ein verbessertes Verfahren und Metallsubstrat zur Kontaktierung von Leistungshalbleitern bereitzustellen.

Diese Aufgabe wird erfindungsgemäß durch ein Verfahren gemäß des Gegenstands des Patentanspruchs 1 gelöst.

Das erfindungsgemäße Verfahren zum Kontaktieren eines Leistungshalbleiters, weist hierfür die folgenden Schritte auf:
Bereitstellen eines Leistungshalbleiters mit zumindest einer Kontaktfläche;
Aufbringen zumindest teilweise auf die Kontaktfläche zumindest ein Kontaktierungsmittel als belastungsreduzierende Struktur und Anordnen zumindest eine Oberfläche eines Metallsubstrats zumindest bereichsweise auf der Kontaktfläche, oder
Aufbringen zumindest teilweise auf die Oberfläche des Metallsubstrats das Kontaktierungsmittel als belastungsreduzierende Struktur und Anordnen zumindest bereichsweise die Kontaktfläche auf der Oberfläche des Metallsubstrats; und
Verbinden der Kontaktfläche mit der Oberfläche des Metallsubstrats.

In diesem Zusammenhang kann der Begriff "Leistungshalbleiter" verwendet werden, um ein elektronisches, beziehungsweise elektrisches Bauelement, zu bezeichnen, das in der Leistungselektronik verwendet wird, wie beispielsweise einen Leistungstransistor. Der Begriff "Kontaktfläche" kann verwendet werden, um einen Bereich oder mehrere Bereiche an dem Elektronikbauteil zu bezeichnen, mit denen eine elektrisch leitende Verbindung hergestellt werden kann.

Als "belastungsreduzierende Struktur" kann eine Struktur verstanden werden, die es ermöglicht mechanische Belastungen oder mechanische Spannungen zu reduzieren. Als "Kontaktierungsmittel" kann ein Mittel mit einer im Wesentlichen festen oder zähflüssigen Konsistenz, wie beispielsweise ein Sintermaterial oder ein Klebstoff verstanden werden, mit dem eine dauerhafte Verbindung zwischen der Kontaktfläche des Leistungshalbleiters und der Oberfläche des Metallsubstrats hergestellt werden kann.

Das erfindungsgemäße Aufbringen der belastungsreduzierenden Struktur kann gemäß einer von zwei Alternativen erfolgen. Erfindungsgemäß wird in einer ersten Alternative das Kontaktierungsmittel als belastungsreduzierende Struktur zumindest teilweise auf die Kontaktfläche aufgebracht und die Oberfläche des Metallsubstrats wird zumindest bereichsweise auf der Kontaktfläche angeordnet. Unter dem Begriff "Anordnen" kann eine temporäre Verbindung, wie beispielsweise ein Aufeinanderlegen verstanden werden. Alternativ hierzu wird in einer zweiten Alternative zumindest teilweise auf die Oberfläche des Metallsubstrats das Kontaktierungsmittel als belastungsreduzierende Struktur aufgebracht und zumindest bereichsweise die Kontaktfläche auf der Oberfläche des Metallsubstrats angeordnet. Bei der zuletzt genannten Alternative kann nach dem Aufbringen des Kontaktierungsmittels und vor dem Anordnen der Kontaktfläche auf der Oberfläche des Metallsubstrats, das Metallsubstrat mit der Oberfläche zunächst auf einem Trägermaterial, beispielsweise auf einer Kunststofffolie, angeordnet werden und an einem anderen Ort weiterverarbeitet werden, beispielsweise kann das Metallsubstrat mittels Pick & Place, von der Trägerfolie abgelöst und auf der Kontaktfläche angeordnet werden.

Der Erfindung liegt die überraschende Erkenntnis zu Grunde, dass alternativ zu dem Einbringen der belastungsreduzierenden Struktur in das Material des Metallsubstrats, auch das Kontaktierungsmittel als belastungsreduzierende Struktur aufgebracht werden kann, um mechanische Spannungen im Kontaktierungsbereich abzubauen und die Wahrscheinlichkeit einer Ablösung der Kontaktierung zu reduzieren.

Vorteilhaft ermöglicht das Aufbringen des Kontaktierungsmittels als belastungsreduzierende Struktur ein Verbinden der Kontaktfläche mit der Oberfläche des Metallsubstrats mit den üblichen Verfahren, ohne dass Anpassungen an den Verfahren, beispielsweise durch Hinzufügung weiterer Verfahrensschritte, vorgenommen werden müssen. Auch ist eine erfindungsgemäße Kontaktierung haltbarer und zuverlässiger als die im Stand der Technik bekannten Kontaktierungen, da auf Materialausnehmungen verzichtet werden kann. Da das Anfertigen von speziellen Stanzwerkzeugen entfällt, kann die belastungsreduzierende einfacher für das jeweilige Einsatzgebiet angepasst werden.

In einem Beispiel umfasst das Aufbringen des Kontaktierungsmittels als belastungsreduzierende Struktur den Schritt:
Aufbringen des Kontaktierungsmittels auf zumindest einen ersten Bereich, bevorzugt auf erste Bereiche, der Kontaktfläche des Leistungshalbleiters oder der Oberfläche des Metallsubstrats, wobei zumindest ein kontaktierungsmittelfreier zweiter Bereich, bevorzugt zweite Bereiche, zwischen den mit Kontaktierungsmittel bedeckten ersten Bereichen angeordnet ist.

Unter "erster Bereich" und "zweiter Bereich" kann jeweils ein zusammenhängender Bereich verstanden werden, der mit Kontaktierungsmittel bedeckt ist oder der frei von Kontaktierungsmittel ist. Diese Begriffe können aber auch als mehrere kleinere Bereiche verstanden werden. Die kleineren Bereiche können mit Kontaktierungsmittel bedeckt sein oder frei von Kontaktierungsmittel sein und die über die Kontaktfläche des Leistungshalbleiters oder der Oberfläche des Metallsubstrats verteilt sein.

Vorteilhaft kann durch das Aufbringen von Kontaktierungsmittel auf bestimmte erste Bereich, wobei auf bestimmten zweiten Bereich, die unterschiedlich sind zu den ersten Bereichen, kein Kontaktierungsmittel aufgebracht wird, die Geometrie der belastungsreduzierenden Struktur bestimmt werden. Im Vergleich zu einem vollflächigen Aufbringen von Kontaktierungsmittel, kann somit auch Kontaktierungsmittel eingespart und Kosten gesenkt werden. Weiterhin kann im Vergleich zu einem vollflächigen Aufbringen von Kontaktierungsmittel, eine Rampenbildung im Druckfeld reduziert bzw. vermieden werden.

In einem Beispiel ist der erste Bereich, bevorzugt die ersten Bereiche, und/oder der zweite Bereich, bevorzugt die zweiten Bereiche, kreisförmig, oval, polygonal, längsförmig entlang einer Geraden oder eines Bogens, und/oder als eine Kombination davon, bevorzugt symmetrisch, noch weiter bevorzugt punktsymmetrisch, angeordnet.

Vorteilhaft können verschiedenste unterschiedliche Geometrien realisiert werden, die beispielsweise durch eine Zusammensetzung von Parallelverschiebungen, Drehungen und Spiegelungen realisiert werden können.

In einem Beispiel stellt der erste Bereich, bevorzugt die ersten Bereiche, mindestens 50%, bevorzugt über 75%, einer zur Verfügung stehenden Fläche dar, und/oder der zweite Bereich, bevorzugt die zweiten Bereiche, stellt mindestens 5%, bevorzugt über 10%, der zur Verfügung stehenden Fläche dar.

Vorteilhaft sind flächenmäßig mehr mit Kontaktierungsmittel bedeckte erste Bereiche vorhanden als kontaktierungsmittelfreie zweite Bereiche, so dass eine haltbare Verbindung zwischen der Kontaktfläche und der Oberfläche des Metallsubstrats hergestellt werden kann.

In einem weiteren Beispiel umfasst das Aufbringen des Kontaktierungsmittels als belastungsreduzierende Struktur:
Aufbringen einer ersten Teilmenge des Kontaktierungsmittels auf zumindest einen ersten Bereich, bevorzugt auf erste Bereiche, der Kontaktfläche des Leistungshalbleiters oder der Oberfläche des Metallsubstrats mit einer ersten Schichtdicke, und
Aufbringen einer zweiten Teilmenge des Kontaktierungsmittels auf zumindest einen zweiten Bereich, bevorzugt auf zweite Bereiche, der Kontaktfläche des Leistungshalbleiters oder der Oberfläche des Metallsubstrats mit einer zweiten Schichtdicke.

Die unterschiedlichen Geometrien können auch realisiert werden durch ein unterschiedlich starkes Aufbringen, bzw. durch Aufbringen des Kontaktierungsmittels mit unterschiedlichen Höhen auf die unterschiedlichen ersten und zweiten Bereiche.

Vorteilhaft kann hierdurch eine noch bessere Verbindung zwischen der Kontaktfläche und der Oberfläche des Metallsubstrats hergestellt werden. In einem Beispiel beträgt die erste und die zweite Schichtdicke mindestens 5µm, und/oder die erste Schichtdicke beträgt 120% bis 150% der zweiten Schichtdicke, bevorzugt 150% bis 200%.

In einem Beispiel umfass das Aufbringen des Kontaktierungsmittels als belastungsreduzierende Struktur: Aufbringen des Kontaktierungsmittels mittels Schablonendruck, Siebdruck, Jetdruck, Dispensen, mittels eines Sprühverfahrens oder als PreForm.

Beim Aufbringen des Kontaktierungsmittels mittels eines Druckverfahrens können verschiedenste Geometrien einfach und schnell aufgebracht werden.

In einem weiteren Beispiel umfasst das Kontaktierungsmittel eine Sinterpaste, insbesondere eine silberhaltige oder kupferhaltige Sinterpaste, oder ein Diffusionslot oder einen Leitkleber oder eine Klebefolie.

Vorteilhaft kann bei der Verwendung einer Sinterpaste das Kontaktierungsmittel aufgesintert werden und somit eine elektrisch strapazierfähige Anbindung geschaffen werden. Alternativ kann es sich bei dem Kontaktierungsmittel auch um einen Leitkleber handeln, der einfach verarbeitet werden kann.

In einem weiteren Beispiel umfasst das Metallsubstrat einen Leadframe, ein Direct Copper Bonded, DCB, Substrat, ein Printed Circuit Board, PCB, Substrat, oder ein mehrlagiges Hybridmetall.

In noch einem weiteren Beispiel umfasst das Verbinden der Kontaktfläche mit dem Metallsubstrat Sintern, bevorzugt Drucksintern, Löten, Diffusionslöten, Kleben oder Verpressen.

Die Erfindung schlägt auch ein Metallsubstrat zum Kontaktieren eines Leistungshalbleiters vor, das Metallsubstrat weist hierfür auf:
zumindest eine Oberfläche mit einem zumindest teilweise auf der Oberfläche aufgebrachten Kontaktierungsmittel als belastungsreduzierende Struktur.

Das Metallsubstrat kann das zuvor beschriebene Metallsubstrat in den beschriebenen Beispielen sein. Das Metallsubstrat kann in einem Beispiel auf einem Trägermaterial, beispielsweise eine Kunststofffolie, angeordnet werden und, beispielsweise mittels Pick & Place, von der Trägerfolie abgelöst und auf der Kontaktfläche des Leistungshalbleiters angeordnet werden.

In einem Beispiel ist das Kontaktierungsmittel auf zumindest einen ersten Bereich, bevorzugt auf erste Bereiche, der Kontaktfläche des Leistungshalbleiters oder der Oberfläche des Metallsubstrats aufgebracht, wobei zumindest ein kontaktierungsmittelfreier zweiter Bereich, bevorzugt zweite Bereiche, zwischen den mit Kontaktierungsmittel bedeckten ersten Bereichen angeordnet ist.

In noch einem Beispiel ist der erste Bereich, bevorzugt die ersten Bereiche, und/oder der zweite Bereich, bevorzugt die zweiten Bereiche, kreisförmig, oval, polygonal, längsförmig entlang einer Geraden oder eines Bogens, und/oder als eine Kombination davon, bevorzugt symmetrisch, noch weiter bevorzugt punktsymmetrisch, angeordnet.

In einem Beispiel stellt der erste Bereich, bevorzugt die ersten Bereiche, mindestens 50%, bevorzugt über 75%, einer zur Verfügung stehenden Fläche dar, und/oder der zweite Bereich, bevorzugt die zweiten Bereiche, stellt mindestens 5%, bevorzugt über 10%, der zur Verfügung stehenden Fläche dar.
In einem weiteren Beispiel ist eine erste Teilmenge des Kontaktierungsmittels auf zumindest einen ersten Bereich, bevorzugt auf erste Bereiche, der Oberfläche des Metallsubstrats mit einer ersten Schichtdicke aufgebracht, und
eine zweite Teilmenge des Kontaktierungsmittels ist auf zumindest einen zweiten Bereich, bevorzugt auf zweite Bereiche, der Oberfläche des Metallsubstrats mit einer zweiten Schichtdicke aufgebracht.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

Dabei zeigt:
- Figur 1a: eine perspektivische Ansicht von zwei Kontaktflächen eines Leistungshalbleiters, zwei Kontaktierungsmitteln als belastungsreduzierende Strukturen und ein Metallsubstrat gemäß einer ersten Ausführungsform vor dem Verbinden;
- Figur 1b: eine perspektivische Ansicht von zwei Kontaktflächen eines Leistungshalbleiters, zwei Kontaktierungsmitteln als belastungsreduzierende Strukturen und ein Metallsubstrat gemäß der ersten Ausführungsform nach dem Verbinden;
- Figur 2a: eine perspektivische Ansicht einer Schicht des Kontaktierungsmittels als belastungsreduzierende Struktur gemäß der ersten Ausführungsform;
- Figur 2b: eine perspektivische Ansicht einer Schicht des Kontaktierungsmittels als belastungsreduzierende Struktur gemäß einer zweiten Ausführungsform;
- Figur 2c: eine perspektivische Ansicht einer Schicht des Kontaktierungsmittels als belastungsreduzierende Struktur gemäß einer dritten Ausführungsform;
- Figur 2d: eine perspektivische Ansicht einer Schicht des Kontaktierungsmittels als belastungsreduzierende Struktur gemäß einer vierten Ausführungsform;
- Figur 3a: eine Schnittansicht durch eine Schicht des Kontaktierungsmittels auf einem Untergrund gemäß der ersten Ausführungsform;
- Figur 3b: eine Schnittansicht durch eine Schicht des Kontaktierungsmittels auf einem Untergrund gemäß einer fünften Ausführungsform; und
- Figur 4: ein erfindungsgemäßes Verfahren zum Kontaktieren eines Leistungshalbleiters.

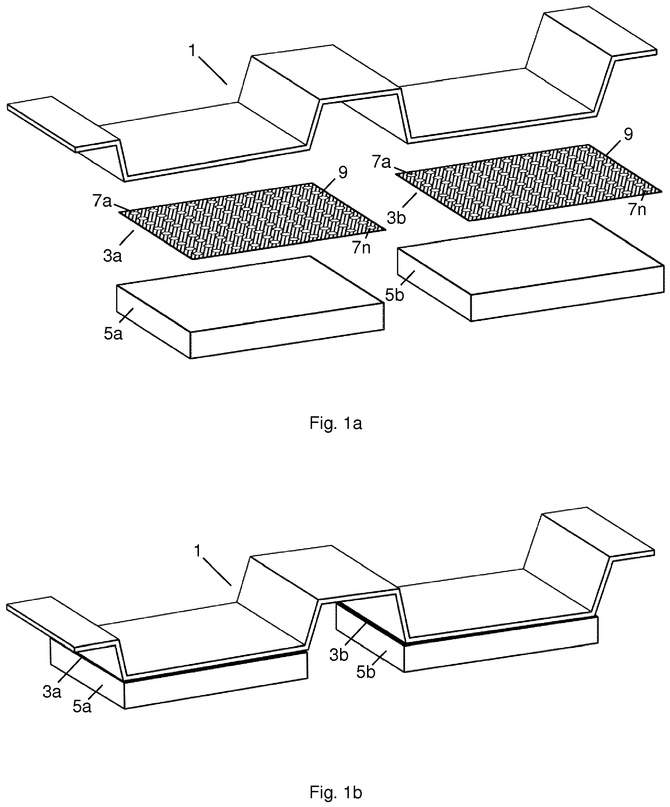

Figur 1a zeigt eine perspektivische Ansicht von zwei Kontaktflächen 5a, 5b eines Leistungshalbleiters, zwei Kontaktierungsmitteln 3a, 3b als belastungsreduzierende Struktur und ein Metallsubstrats 1 gemäß einer ersten Ausführungsform vor dem Verbinden.

Die Kontaktflächen 5a, 5b des Leistungshalbleiters können beispielsweise die Kontaktflächen 5a, 5b eines Leistungstransistors sein und sind in der gezeigten Ausführungsform horizontal angeordnet, haben eine im Wesentlichen ebene Oberfläche und dienen der elektrischen Kontaktierung des Leistungshalbleiters. Die Kontaktflächen 5a, 5b umfassen ein elektrisch leitendes Material und können abhängig von der gewünschten Verwendung zusätzlich noch bereichsweise vergoldet oder versilbert sein.

In Figur 1a werden zwei Kontaktierungsmittel 3a, 3b zum Verbinden der Kontaktflächen 5a, 5b mit der Oberfläche des Metallsubstrats 1 gezeigt. In der Figur 1a befinden sich die Kontaktierungsmittel 3a, 3b als belastungsreduzierende Strukturen zwischen den Kontaktflächen 5a, 5b und dem Metallsubstrat 1. Erfindungsgemäß sind die Kontaktierungsmittel 3a, 3b entweder zumindest teilweise auf den Kontaktflächen 5a, 5b aufgebracht, oder zumindest teilweise auf dem Metallsubstrat 1. Aufgebracht werden können die Kontaktflächen 5a, 5b beispielsweise mittels Schablonendruck, Siebdruck, Jetdruck, Dispensen, mittels eines Sprühverfahrens oder als PreForm.

In der gezeigten Ausführungsform ist das Kontaktierungsmittel 3a, 3b in einem ersten Bereich 9 angeordnet, der in den gezeigten Figuren schraffiert dargestellt ist, dazwischen sind kontaktierungsmittelfreie zweite Bereiche 7a - 7n kreisförmig angeordnet, die in den Figuren nicht ausgefüllt sind, um die belastungsreduzierende Struktur zu bilden. In dem gezeigten Beispiel sind die zweiten Bereiche 7a - 7n kreisförmig ausgestaltet und die ersten Bereiche in Form eines ersten Bereichs 9 um die zweiten Bereiche 7a - 7n angeordnet. In weiteren, nicht in Figur 1a gezeigten Ausführungsformen, sind die ersten Bereiche oder die zweiten Bereiche oval, polygonal, längsförmig entlang einer Geraden oder eines Bogens, und/oder als eine Kombination davon, symmetrisch, oder punktsymmetrisch, angeordnet.

Wie es in Figur 1a gezeigt wird, hat das Metallsubstrat 1 zwei im Wesentlichen ebene, bzw. flache Oberflächen in den Bereichen in denen das Metallsubstrat 1 mit den Kontaktierungsmitteln 3a, 3b in Verbindung steht. Zwischen den ebenen Oberflächen ist das Metallsubstrat 1 gebogen, um beanstandet von der Oberfläche des Leistungshalbleiters zu verlaufen. In nicht gezeigten Ausführungsformen kann das Metallsubstrat aber auch vollständig flach ausgestaltet sein.

Figur 1b zeigt eine perspektivische Ansicht von den beiden Kontaktflächen 5a, 5b, den beiden Kontaktierungsmitteln 3a, 3b als belastungsreduzierende Strukturen und dem Metallsubstrat 1 gemäß der ersten Ausführungsform nach dem Verbinden. Das Verbinden der Kontaktflächen 5a, 5b mit dem Metallsubstrat 1 kann abhängig von dem verwendeten Kontaktierungsmittel 3a, 3b durch Sintern, bevorzugt Drucksintern, Löten, Diffusionslöten, Kleben, oder Verpressen erfolgen, um eine elektrisch und mechanisch dauerhafte Verbindung herzustellen.

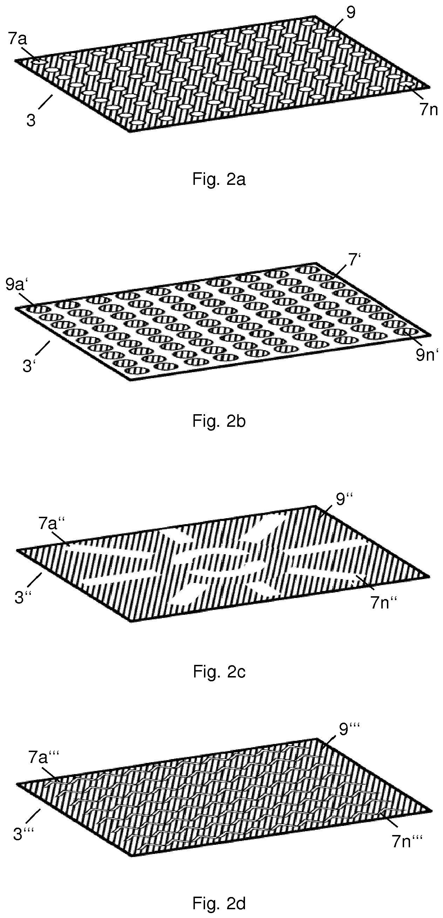

Figur 2a zeigt eine perspektivische Ansicht einer Schicht des Kontaktierungsmittels 3 als belastungsreduzierende Struktur gemäß der ersten Ausführungsform, wie sie bereits in der Figur 1a gezeigt ist. In der gezeigten Ausführungsform ist das Kontaktierungsmittel 3 in einem ersten Bereich 9 angeordnet, dazwischen sind kontaktierungsmittelfreie zweite Bereiche 7a - 7n kreisförmig angeordnet, um die belastungsreduzierende Struktur zu bilden. In dem gezeigten Beispiel sind die zweiten Bereiche 7a - 7n kreisförmig ausgestaltet und die ersten Bereiche in Form eines einzigen ersten Bereichs 9 um die zweiten Bereiche 7a - 7n angeordnet.

Figur 2b zeigt eine perspektivische Ansicht einer Schicht des Kontaktierungsmittels 3' als belastungsreduzierende Struktur gemäß einer zweiten Ausführungsform. In der gezeigten Ausführungsform ist das Kontaktierungsmittel 3' in ersten Bereichen 9a' - 9n' kreisförmig angeordnet, dazwischen ist ein kontaktierungsmittelfreier zweiter Bereich 7' angeordnet, um die belastungsreduzierende Struktur zu bilden. In dem gezeigten Beispiel sind die erste Bereiche 9a' - 9n' kreisförmig ausgestaltet und die ersten Bereiche 9a' - 9n' um den zweiten Bereiche 7' angeordnet.

Figur 2c zeigt eine perspektivische Ansicht einer Schicht des Kontaktierungsmittels 3" als belastungsreduzierende Struktur gemäß einer dritten Ausführungsform. In der gezeigten dritten Ausführungsform ist das Kontaktierungsmittel 3" in einem ersten Bereich 9" angeordnet, dazwischen sind kontaktierungsmittelfreie zweite Bereiche 7a" - 7n" strahlenförmig um eine Mitte angeordnet, um die belastungsreduzierende Struktur zu bilden.

Figur 2d zeigt eine perspektivische Ansicht einer Schicht des Kontaktierungsmittels 3'" als belastungsreduzierende Struktur gemäß einer vierten Ausführungsform. In der gezeigten vierten Ausführungsform ist das Kontaktierungsmittel 3'" in einem ersten Bereich 9'" angeordnet, dazwischen sind kontaktierungsmittelfreie zweite Bereiche 7a'" - 7n'" wellenförmig angeordnet, um die belastungsreduzierende Struktur zu bilden.

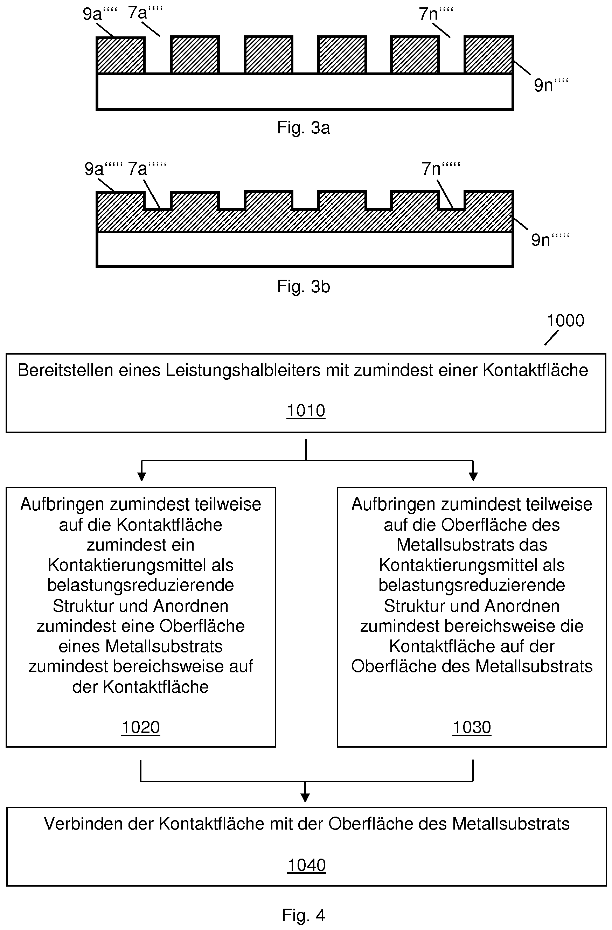

In Figur 3a ist eine Schnittansicht durch eine Schicht des Kontaktierungsmittels auf einem Untergrund gemäß der ersten Ausführungsform gezeigt. Der Untergrund kann die Kontaktfläche des Kontaktierungsmittels oder die Oberfläche des Metallsubstrats sein. Wie es in der Figur 3a gezeigt wird, ist das Kontaktierungsmittel in ersten Bereichen 9a"" - 9n"" angeordnet, dazwischen sind die zweiten Bereiche 7a"" - 7n"" angeordnet, die im Wesentlichen vollständig kontaktierungsmittelfrei sind.

Figur 3b zeigt eine Schnittansicht durch eine Schicht des Kontaktierungsmittels auf einem Untergrund gemäß einer fünften Ausführungsform. Im Gegensatz zu der in Figur 3a gezeigten Schnittansicht, ist hier nicht nur Kontaktierungsmittel in den ersten Bereichen 9a'"" - 9n'"" angeordnet, sondern auch in den zweiten Bereichen 7a'"" - 7n'"". In dem gezeigten Beispiel beträgt die Schichtdicke in den zweiten Bereichen 7a'"" - 7n'"" ungefähr die Hälfte der Schichtdicke in den ersten Bereichen 9a'"" - 9n'"".

Figur 4 zeigt ein erfindungsgemäßes Verfahren 1000 zum Kontaktieren eines Leistungshalbleiters. Das Verfahren weist die Schritte auf:
Bereitstellen 1010 eines Leistungshalbleiters mit zumindest einer Kontaktfläche;
Aufbringen 1020 zumindest teilweise auf die Kontaktfläche zumindest ein Kontaktierungsmittel als belastungsreduzierende Struktur und Anordnen zumindest eine Oberfläche eines Metallsubstrats zumindest bereichsweise auf der Kontaktfläche, oder
Aufbringen 1030 zumindest teilweise auf die Oberfläche des Metallsubstrats das Kontaktierungsmittel als belastungsreduzierende Struktur und Anordnen zumindest bereichsweise die Kontaktfläche auf der Oberfläche des Metallsubstrats; und
Verbinden 1040 der Kontaktfläche mit der Oberfläche des Metallsubstrats.

Weitere Merkmale und Vorteile der Erfindung ergeben sich aus der nachfolgenden Beschreibung, in der bevorzugte Ausführungsformen der Erfindung anhand von schematischen Zeichnungen erläutert sind.

### Bezugszeichenliste

- 1: Metallsubstrat
- 3, 3a, 3b, 3', 3", 3'": Kontaktierungsmittel
- 5a, 5b: Kontaktfläche
- 7a, 7', 7a" - 7a'"", 7n, 7n" - 7n'"": zweiter Bereich
- 9, 9a', 9n', 9", 9"', 9a'"", 9n"", 9a'"", 9n'"": erster Bereich

- 1000: Verfahren zum Kontaktieren eines Leistungshalbleiters
- 1010: Bereitstellen
- 1020: Aufbringen (erste Alternative)
- 1030: Aufbringen (zweite Alternative)
- 1040: Verbinden

## Patentansprüche

1. Verfahren zum Kontaktieren eines Leistungshalbleiters, aufweisend die Schritte:
Bereitstellen eines Leistungshalbleiters mit zumindest einer Kontaktfläche;
Aufbringen zumindest teilweise auf die Kontaktfläche zumindest ein Kontaktierungsmittel als belastungsreduzierende Struktur und Anordnen zumindest eine Oberfläche eines Metallsubstrats zumindest bereichsweise auf der Kontaktfläche, oder
Aufbringen zumindest teilweise auf die Oberfläche des Metallsubstrats das Kontaktierungsmittel als belastungsreduzierende Struktur und Anordnen zumindest bereichsweise die Kontaktfläche auf der Oberfläche des Metallsubstrats; und
Verbinden der Kontaktfläche mit der Oberfläche des Metallsubstrats.

2. Verfahren nach Anspruch 1, wobei das Aufbringen des Kontaktierungsmittels als belastungsreduzierende Struktur umfasst:
Aufbringen des Kontaktierungsmittels auf zumindest einen ersten Bereich, bevorzugt auf erste Bereiche, der Kontaktfläche des Leistungshalbleiters oder der Oberfläche des Metallsubstrats, wobei zumindest ein kontaktierungsmittelfreier zweiter Bereich, bevorzugt zweite Bereiche, zwischen den mit Kontaktierungsmittel bedeckten ersten Bereichen angeordnet ist.

3. Verfahren nach Anspruch 1 oder 2, wobei der erste Bereich, bevorzugt die ersten Bereiche, und/oder der zweite Bereich, bevorzugt die zweiten Bereiche, kreisförmig, oval, polygonal, längsförmig entlang einer Geraden oder eines Bogens, und/oder als eine Kombination davon, bevorzugt symmetrisch, noch weiter bevorzugt punktsymmetrisch, angeordnet ist.

4. Verfahren nach Anspruch 3, wobei der erste Bereich, bevorzugt die ersten Bereiche, mindestens 50%, bevorzugt über 75%, einer zur Verfügung stehenden Fläche darstellen, und/oder
wobei der zweite Bereich, bevorzugt die zweiten Bereiche, mindestens 5%, bevorzugt über 10%, der zur Verfügung stehenden Fläche darstellen.

5. Verfahren nach Anspruch 1, wobei das Aufbringen des Kontaktierungsmittels als belastungsreduzierende Struktur umfasst:
Aufbringen einer ersten Teilmenge des Kontaktierungsmittels auf zumindest einen ersten Bereich, bevorzugt auf erste Bereiche, der Kontaktfläche des Leistungshalbleiters oder der Oberfläche des Metallsubstrats mit einer ersten Schichtdicke, und
Aufbringen einer zweiten Teilmenge des Kontaktierungsmittels auf zumindest einen zweiten Bereich, bevorzugt auf zweite Bereiche, der Kontaktfläche des Leistungshalbleiters oder der Oberfläche des Metallsubstrats mit einer zweiten Schichtdicke.

6. Verfahren nach Anspruch 5, wobei die erste und die zweite Schichtdicke mindestens 5µm beträgt, und/oder wobei die erste Schichtdicke 120% bis 150% der zweiten Schichtdicke beträgt, bevorzugt 150% bis 200%.

7. Verfahren nach einem der vorangehenden Ansprüche, wobei das Aufbringen des Kontaktierungsmittels als belastungsreduzierende Struktur umfasst:
Aufbringen des Kontaktierungsmittels mittels Schablonendruck, Siebdruck, Jetdruck, Dispensen, mittels eines Sprühverfahrens oder als PreForm.

8. Verfahren nach einem der vorangehenden Ansprüche, wobei das Kontaktierungsmittel eine Sinterpaste, insbesondere eine silberhaltige oder kupferhaltige Sinterpaste, oder ein Diffusionslot oder einen Leitkleber oder eine Klebefolie umfasst.

9. Verfahren nach einem der vorangehenden Ansprüche, wobei das Metallsubstrat einen Leadframe, ein Direct Copper Bonded, DCB, Substrat, ein Printed Circuit Board, PCB, Substrat, oder ein mehrlagiges Hybridmetall umfasst.

10. Verfahren nach einem der vorangehenden Ansprüche, wobei das Verbinden der Kontaktfläche mit dem Metallsubstrat umfasst Sintern, bevorzugt Drucksintern, Löten, Diffusionslöten, Kleben, oder Verpressen.

11. Metallsubstrat zum Kontaktieren eines Leistungshalbleiters, aufweisend:
zumindest eine Oberfläche mit einem zumindest teilweise auf der Oberfläche aufgebrachten Kontaktierungsmittel als belastungsreduzierende Struktur.

12. Metallsubstrat nach Anspruch 11, wobei das Kontaktierungsmittel auf zumindest einen ersten Bereich, bevorzugt auf erste Bereiche, der Kontaktfläche des Leistungshalbleiters oder der Oberfläche des Metallsubstrats aufgebracht ist, wobei zumindest ein kontaktierungsmittelfreier zweiter Bereich, bevorzugt zweite Bereiche, zwischen den mit Kontaktierungsmittel bedeckten ersten Bereichen angeordnet ist.

13. Metallsubstrat nach Anspruch 11 oder 12, wobei der erste Bereich, bevorzugt die ersten Bereiche, und/oder der zweite Bereich, bevorzugt die zweiten Bereiche, kreisförmig, oval, polygonal, längsförmig entlang einer Geraden oder eines Bogens, und/oder als eine Kombination davon, bevorzugt symmetrisch, noch weiter bevorzugt punktsymmetrisch, angeordnet ist.

14. Metallsubstrat nach Anspruch 13, wobei der erste Bereich, bevorzugt die ersten Bereiche, mindestens 50%, bevorzugt über 75%, einer zur Verfügung stehenden Fläche darstellen, und/oder
wobei der zweite Bereich, bevorzugt die zweiten Bereiche, mindestens 5%, bevorzugt über 10%, der zur Verfügung stehenden Fläche darstellen.

15. Metallsubstrat nach Anspruch 11, wobei eine erste Teilmenge des Kontaktierungsmittels auf zumindest einen ersten Bereich, bevorzugt auf erste Bereiche, der Oberfläche des Metallsubstrats mit einer ersten Schichtdicke aufgebracht ist, und
eine zweite Teilmenge des Kontaktierungsmittels auf zumindest einen zweiten Bereich, bevorzugt auf zweite Bereiche, der Oberfläche des Metallsubstrats mit einer zweiten Schichtdicke aufgebracht ist.
